(19) **Europäisches Patentamt**

**European Patent Office**

**Office européen des brevets**

(11) **EP 1 115 002 B1**

(12) **EUROPEAN PATENT SPECIFICATION**

(45) Date of publication and mention
of the grant of the patent:
**16.10.2002 Bulletin 2002/42**

(51) Int Cl.7: **G01R 27/02**

(21) Application number: **99124681.0**

(22) Date of filing: **10.12.1999**

(54) **Apparatus for accurately measuring impedance and method used therein**

Gerät und Verfahren zur genauen Messung von Impedanzen

Appareil et procédé de mesure précise d'impédance

(84) Designated Contracting States:
**DE FR GB**

(43) Date of publication of application:
**11.07.2001 Bulletin 2001/28**

(73) Proprietor: **NEC CORPORATION**
**Tokyo (JP)**

(72) Inventor: **Yukawa, Akira, c/o NEC Corporation**
**Tokyo (JP)**

(74) Representative: **Glawe, Delfs, Moll & Partner**
**Patentanwälte**
**Postfach 26 01 62**
**80058 München (DE)**

(56) References cited:
**EP-A- 0 271 849          EP-A- 0 417 708**
**US-A- 5 225 756          US-A- 5 467 294**

- **PATENT ABSTRACTS OF JAPAN vol. 11, no. 121 (P-568), 16 April 1987 (1987-04-16) & JP 61 266965 A (SANWA DENKI), 26 November 1986 (1986-11-26)**

**Description**

FIELD OF THE INVENTION

This invention relates to a measurement of impedance and, more particularly, to an apparatus for measuring impedance and a method used therein.

DESCRIPTION OF THE RELATED ART

In the following description, term "impedance" means an absolute value of the impedance of an electric circuit, a value of the real part, a value of the imaginary part and a ratio therebetween. A typical example of the apparatus for measuring impedance is disclosed in Japanese Patent Publication of Unexamined Application No. 61-266965. Figure 1 illustrates the prior art apparatus for measuring impedance. Although the references are different, figure 1 is corresponding to figure 1 disclosed in the Japanese Patent Publication of Unexamined Application.

The prior art apparatus measures the impedance of a target circuit 100. The target circuit 100 is assumed to be a capacitive element, and has an admittance Y expressed as Y = G + jB where G is a conductance and B is susceptance. The prior art apparatus comprises a source of alternating current 102, a current-to-voltage converter 103, a phase discriminator 104, a phase shifter 105, a phase discriminator 106, a comparator 107, a switching unit 108 and an analog-to-digital converter 110. The source of alternating current 102 applies a voltage e to the target circuit, and a current ig flows out from the target circuit 100 into the current-to-voltage converter 103. The amount of current is expressed as e(G + jB). The current-to-voltage converter 103 converts the current ig to an output voltage ey, and the output voltage ey is equal to - R × ig. The output voltage ey is applied to the phase discriminators 104 and 106.

The phase discriminator 104 multiplies the voltage ey by the output voltage e of the source of alternating current 102, and extracts the direct current component. The phase discriminator 104 outputs a dc voltage ea proportional to the conductance G. On the other hand, the other phase discriminator 106 multiplies the voltage ey by the output voltage of the phase shifter 105. The phase shifter 105 is supplied with the voltage e of the source of alternating current 102, and introduces a phase lag of 90 degrees between the voltage e and the output voltage. For this reason, the phase discriminator 106 outputs a dc voltage eb proportional to the susceptance B.

The switching unit 108 has two input nodes 109a and 109b. The dc voltage ea is applied to the input terminal 109a, and the other dc voltage eb is applied to the other input terminal 109b. The switching unit 108 selectively supplies the dc voltages ea and eb to the analog-to-digital converter 110, and the analog-to-digital converter 110 converts the dc voltages ea/ eb to a digital signal.

The prior art measuring apparatus further comprises a microcomputer 111, an ac voltage-to-dc voltage converter 112, an analog-to-digital converter 113 and display units 114a/ 114b. The output voltage ey is supplied to the ac voltage-to- dc voltage converter 112, and the ac voltage-to-dc voltage converter 112 produces a dc voltage from the output voltage ey. The dc voltage is proportional to absolute value of the admittance Y. The dc voltage is supplied to the analog-to-digital converter 113, and is converted to a digital signal.

The analog-to-digital converters 110 and 113 are connected to the microcomputer 111. The microcomputer 111 calculates the conductance G and the susceptance B on the basis of the digital signal supplied from the analog-to-digital converter 110, and the displays 114a/ 114b indicate the conductance G, the susceptance B, respectively. The microcomputer calculates the absolute value of the admittance on the basis of the digital signal supplied from the analog-to-digital converter 113.

The comparator 107 behaves as follows. The de voltage ea is compared with the dc voltage eb. If the admittance Y is much greater than the conductance G, i.e., Y >> G, the susceptance B is expressed as

$$B = \sqrt{(Y^2 - G^2)} \fallingdotseq Y$$

For this reason, the microcomputer 111 ignores the digital signal converted from the dc voltage eb, and calculates the susceptance B on the basis of the digital signal supplied from the analog-to-digital converter 113.

On the other hand, when the admittance Y is much greater than the susceptance B, i.e., Y >> B, the conductance G is expressed as

$$C = \sqrt{(Y^2 - B^2)} \fallingdotseq Y$$

For this reason, the microcomputer 111 ignores the digital signal converted from the dc voltage ea, and calculates the conductance G on the basis of the digital signal supplied from the analog-to-digital converter 113. This is because of the fact that the ac voltage-to-dc voltage converter 112 is much higher in accuracy than the phase discriminators 104/106. In fact, the error introduced by the phase discriminators 104/ 106 is of the order of 0.1 to 0.2 percent. On the other hand, the error introduced by the ac voltage-to-dc voltage converter 112 is of the order of 0.01 percent. Thus, the microcomputer 111 gives the priority to the digital signal supplied from the ac voltage-to-dc voltage converter 112 through the analog-to-digital converter 113, and enhances the accuracy.

The Japanese Patent Publication of Unexamined Application further discloses an apparatus for measuring an impedance of an inductive element. The resistance R, the reactance X and the impedance Z are measured in a similar manner to that described hereinbefore. The microcomputer also gives the priority to the digital signal converted from the dc voltage representative of the impedance Z, and calculates the resistance R or the reactance X on the basis of the digital signal under the condition of Z >> X or Z >> R.

Although the priority given to the ac voltage-to-dc voltage converter 112 fairly improves the accuracy of the measurement, i.e., either conductance or susceptance under the conditions of Y>> G or Y>> B, the measurement still contains the susceptance or the conductance calculated on the basis the digital signal converted from the dc voltage eb or ea. When the admittance Y is not much greater than the conductance G and the susceptance B, both of the conductance G and the susceptance B are calculated on the basis of the digital signals converted from the dc voltages ea and eb. Thus, the prior art apparatus still has a problem in the accuracy of the measurement. This is the first problem inherent in the prior art apparatus.

The second problem is a noise component due to the dc offset voltage in the phase discriminators 104/106. The prior art apparatus is connected to various kinds of electric circuits 105, and the phase discriminators 104 and 106 require a dc amplification for the dynamic range. The dc voltages ea and eb contain the dc offset voltage, and the dc offset voltage is transferred to the digital signal through the analog-to-digital conversion. Thus, the digital signal contains the noise component, and the noise component deteriorates the measurement. This is the second problem inherent in the prior art apparatus.

The third problem is the phase shifter 105. Although the phase shifter 105 targets the phase lag for 90 degrees, the phase shifter can not shift the output voltage e by 90 degrees at all times. This means that the analog multiplication is not accurate.

The same problems are encountered in the prior art apparatus used for an inductive element.

EP-A-0 271 849 shows an apparatus for measuring an impedance of an object according to the preamble part of claim 1 and 15.

EP-A-0 417 708 shows an impedance and transfer characteristic measuring apparatus producing sine wave and cosine wave data using data obtained by an accumulating a fixed face value in synchronismn with a clock signal.

SUMMARY OF THE INVENTION

It is therefore an important object of the present invention to provide an apparatus for accurately measuring an impedance.

It is also an important object of the present invention to provide a method for accurately measuring an impedance.

This objects are solved by the features of claims 1 and 15. Advantageous embodiments are shown in the sub-claims.

BRIEF DESCRIPTION OF THE DRAWINGS

The features and advantages of the measuring apparatus and the method will be more clearly understood from the following description taken in conjunction with the accompanying drawings in which:

Fig. 1 is a block diagram showing the circuit configuration of the prior art measuring apparatus disclosed in Japanese Patent Publication of Unexamined Application No. 61-266965;

Fig. 2 is a block diagram showing the circuit configuration of a measuring apparatus according to the present invention;

Fig. 3 is a graph showing relation between a normalized angular frequency and a gain;

Fig. 4 is a block diagram showing the circuit configuration of another measuring apparatus according to the present invention;

Fig. 5 is a block diagram showing the circuit configuration of yet another measuring apparatus according to the present invention; and

Fig. 6 is a block diagram showing the circuit configuration of still another measuring apparatus according to the present invention.

DESCRIPTION OF THE PREFERRED EMBODIMENTS

First Embodiment

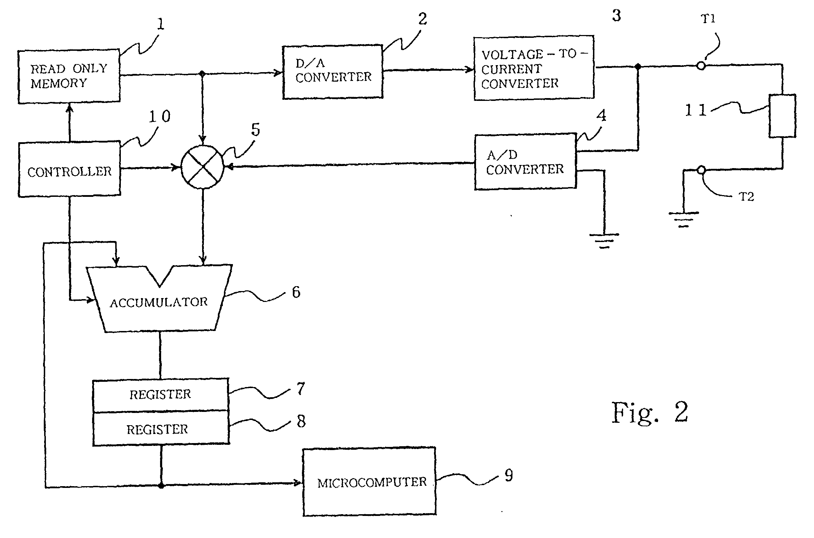

Referring to figure 2 of the drawings, a measuring apparatus embodying the present invention comprises a read only memory 1, a digital-to-analog converter 2, a voltage-to-current converter 3, an analog-to-digital converter 4, a multiplier 5, an accumulator 6, registers 7 and 8, a microcomputer 9 and a controller 10. An object 11 is connected between the measuring apparatus and the ground, and the impedance of the object 11 is to be measured.

The read only memory 1 stores discrete values representative of a quarter of a sine wave, and the discrete values are stored in terms of time. The sine wave has an angular frequency $\omega0$. The discrete values are repeatedly read out from the read only memory 1, and are supplied to the voltage-to-current converter 3 through the digital-to-analog converter 2. An alternating current is generated from the discrete values, and the alternating current flows into the object 11. The alternating current is converted to ac voltage, and the analog-to-digital converter 4 digitizes the ac voltage. The microcomputer 9 calculates the impedance of the object 11 at the angular frequency $\omega0$ on the basis of the digital data signal representative of the ac voltage and the discrete values.

The controller 10 supervises the read only memory 1, the multiplier 5 and the accumulator 6. In detail, the controller 10 reads out the discrete values from the read only memory 1. As described hereinbefore, the discrete values represent the quarter of the sine wave, and the controller 10 sequentially addresses the memory locations as follows. First, the controller 10 sequentially reads out the discrete values in regular order, and, thereafter, reversely reads out them. Subsequently, the controller 10 instructs the read only memory 1 to invert the polarity of the discrete values, and reads out the discrete values in the regular order. Finally, the controller 10 reversely reads out the discrete values inverted in polarity. Then, the sine wave is generated from the discrete values.

A cosine wave is further generated from the discrete values. The controller 10 repeats the generation of the sine wave and the generation of the cosine wave in a time sharing fashion. First, the controller 10 reversely reads out the discrete values. The controller 10 instructs the read only memory 1 to invert the polarity of the discrete values, and reads out the discrete values inverted in polarity in the regular order. Subsequently, the controller 10 reversely reads out the discrete values inverted in polarity. Finally, the controller 10 reads out the discrete values in the regular order without inversion in polarity. The cosine wave is different in phase from the sine wave by 90 degrees.

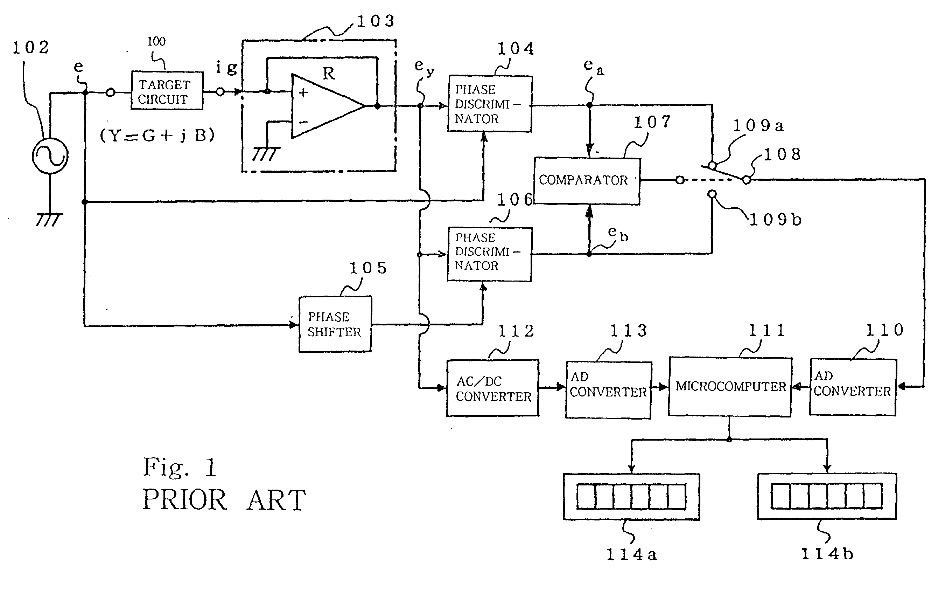

The digital-to-analog converter 2 converts the series of discrete values representative of the sine wave or the cosine wave to an analog signal. The analog signal varies the voltage level, and is supplied to the voltage-to-current converter 3. The voltage-to-current converter 3 produces the alternating current from the analog voltage signal, and supplies it to the object 11. The voltage-to-current converter 3 may be implemented by an operational amplifier shown in figure 1.

When the alternating current flows into the object 11. the amount of alternating current is multiplied by the impedance of the object 11. The product is represented by the ac voltage. The ac voltage is representative of the sine wave and the cosine wave in the time sharing fashion. The ac voltage is supplied to the analog-to-digital converter 4, and is converted to the digital signal. The digital signal is supplied to the multiplier 5.

The multiplier 5 multiplies the digital signal by the discrete value representative of a part of the sine wave. The multiplier 5 further multiplies the digital signal by the discrete value representative of a part of cosine wave. Although the discrete values stored in the read only memory 1 represents the quarter of the sine wave having the angular frequency $\omega0$ only. However, the signal processing from the digital-to-analog conversion to the analog-to-digital conversion introduces the quantizing noise and external noises into the digital signal. For this reason, the digital signal represents a sine wave of a cosine wave both having various angular frequencies $\omega$ together with the angular frequency $\omega0$. However, description is firstly made on the principle of the measurement according to the present invention on the assumption that the digital signal represents the sine wave and the cosine wave at the angular frequency $\omega0$ without consideration of differences between direct current and alternating current.

Assuming now that the sine wave $\sin\omega0\ t$ represents the alternating current, the impedance of the object 11 affects the alternating current, and the response functions are the sine wave $\sin\omega0\ t$ due to the real part of the impedance and the cosine wave $\cos\omega0\ t$ due to the imaginary part of the impedance. As described hereinbefore, the multiplier 5 multiplies the digital signal by the discrete values representing the sine wave $\sin\omega0\ t$ and the cosine wave $\cos\omega\ 0\ t$ at different timings. When the multiplier 5 multiplies the values on the sine wave $\sin\omega0$ and the values on the cosine wave $\cos\omega0$ by the discrete values representing the sine wave $\sin\omega0\ t$, the real part of the impedance causes the product to contain $\sin^2\omega0\ t = 1/2\ (1 - \cos2\omega0\ t)$, and the imaginary part of the impedance causes the product to contain $\sin\omega0\ t \times \cos\omega0\ t = 1/2\ \sin2\omega0\ t$. The alternating current components $\cos2\omega0$ and $\sin2\omega0\ t$ are subtracted from the product, a digital signal representing the difference has a value proportional to the real part.

On the other hand, when the multiplier 5 multiplies the values on the sine wave $\sin\omega0$ and the values on the cosine wave $\cos\omega0$ by the discrete values representing the cosine wave $\cos\omega0\ t$, the real part of the impedance causes the product to contain $\cos\omega0\ t \times \sin\omega0\ t = 1/2\sin2\omega0\ t$, and the imaginary part of the impedance causes the product

to contain $\cos\omega 0\ t \times \cos\omega 0\ t = 1/2(1 + \cos 2\omega 0\ t)$. After the elimination of the alternating current components, the digital signal is proportional to the imaginary part of the impedance.

The accumulator 6 eliminates the alternating current components from the digital signal representative of the products. The accumulator 6 successively adds the products over plural periods. If the digital signal supplied from the analog-to-digital converter 4 does not contain the quantizing noise and the external noises, the alternating current components are $\sin 2\omega 0\ t$ and $\cos 2\omega 0\ t$ only, and the alternating current components are eliminated from the digital signal through the accumulation over only one period. However, the digital signal supplied to the multiplier 5 unaviodably contains the quantizing noise and the external noises. In order to eliminate those noise components and the alternating current components from the products, the accumulator 6 accumulates the products over a hundred periods or more. The results of the accumulation, a sum of products and another sum of products are separately supplied to the registers 7 and 8, and are stored therein. The registers 7 and 8 are assigned to a sine term and a cosine term, respectively, as will be described hereinlater.

Upon completion of the accumulation, the microcomputer 9 fetches the digital values representative of the sums of products from the registers 7 and 8. The microcomputer 9 brings the sums of products to squares, respectively, and adds the squares to one another. The microcomputer 9 finds the square root of the sum. The square root is proportional to the absolute value of the impedance. The microcomputer 9 determines the ratio of the sum, which is equal to the ratio of the real part to the imaginary part, i.e., the phase angle $\tan\theta$.

The digital signal vi supplied to the multiplier 5 is assumed to be expressed as $A\sin(\omega t + \phi)$. When the multiplier 5 carries out the multiplication on the digital values representative of parts of the sine wave and the digital values representative of parts of the cosine wave over n periods, the accumulator 6 stores a sine term $Hs(\omega)$ and a cosine term $Hc(\omega)$ in the registers 7 and 8, respectively. The sine term $Hs(\omega)$ and the cosine term $Hc(\omega)$ are expressed as

$$Hs(\omega) = \int_0^{2n\pi/\omega 0} vi\ \sin(\omega 0 t)\ dt$$

$$Hc(\omega) = \int_0^{2n\pi/\omega 0} vi\ \cos(\omega 0 t)\ dt\ ]$$

First, the sine term $Hs(\omega)$ is calculated as

$$Hs(\omega) = \int_0^{2n\pi/\omega 0} Ai\sin(\omega t + \psi)\ \sin(\omega 0 t)dt$$

$$= (Ai/2) \int_0^{2n\pi/\omega 0} [\cos\{(\omega-\omega 0)\ t + \psi\}- \cos\{((\omega+\omega 0)\ t + \psi\}]\ dt$$

If $\omega=\omega 0$, the sine term $Hs(\omega)$ is given as

$$Hs(\omega) = (Ai/2) \int_0^{2n\pi/\omega 0} \{\cos(\psi) - \cos(2\omega 0 t + \psi)\}dt$$

$$= n\pi\ Ai \times \cos(\psi)\ /\ \omega 0$$

On the other hand, if $\omega \neq \omega 0$, the sine term $Hs(\omega)$ is given as

$$Hs(\omega) = (Ai/2)\ [[\sin\{(\omega-\omega 0)t+\psi\}/(\omega-\omega 0)]-$$

$$[\sin\{(\omega+\omega 0)t+\psi\}/(\omega+\omega 0)]]_0^{2n\pi/\omega 0}$$

$$= (Ai/2)\ [[\sin\{2n\pi((\omega/\omega 0)-1) + \psi\} - \sin(\psi)]/(\omega-\omega 0) -$$

$$[\sin\{2n\pi((\omega/\omega 0)+1) + \psi\} - \sin(\psi)]/(\omega+\omega 0)]]$$

$$= (Ai/2)\ \{\sin\{2n(\omega/\omega 0)\pi + \psi\} - \sin(\psi)\}\ \{2\omega 0/(\omega^2-\omega 0^2)]$$

$$= 2\ Ai\cos\{n(\omega/\omega 0)\ \pi + \psi\}\ \sin\{n(\omega/\omega 0)\pi\}\{\omega 0/(\omega^2-\omega 0^2)\}$$

The cosine term $Hc(\omega)$ is expressed as

$$Hc(\omega) = \int_0^{2n\pi/\omega0} Ai\sin(\omega t + \psi)\cos(\omega 0t)dt$$

$$= (Ai/2) \int_0^{2n\pi/\omega0} [\sin\{(\omega + \omega0) t + \psi\} + \sin\{((\omega - \omega0) t + \psi\}] dt$$

If $\omega = \omega0$, the sine term $Hc(\omega)$ is given as

$$Hc(\omega) = (Ai/2) \int_0^{2n\pi/\omega0} \{\sin(2\omega0t + \psi) + \sin(\psi)\}dt$$

$$= n\pi \ Ai \times \sin(\psi)/\omega0$$

On the other hand, if $\omega \neq \omega0$, the cosine term $Hc(\omega)$ is given as

$$Hc(\omega) = -(Ai/2) [[\cos\{(\omega+\omega0) t + \psi\}/ (\omega+\omega0)] +$$

$$[\cos\{(\omega-\omega0) t + \psi\}/ (\omega-\omega0)]]_0^{2n\pi/\omega0}$$

$$= -(Ai/2) [[\cos\{2n\pi((\omega/ \omega0)+1) + \psi\} - \cos(\psi)]/(\omega+\omega0) +$$

$$[\cos\{2n\pi((\omega/ \omega0)-1) + \psi\} - \cos(\psi)]/ (\omega-\omega0)]]$$

$$= -(Ai/2) \{\cos\{2n(\omega/ \omega0)\pi + \psi\} - \cos(\psi)\} [\{1/(\omega+\omega0)\}+$$

$$\{1/(\omega-\omega0)\}]$$

$$= 2 Ai\sin\{n(\omega/ \omega0) \pi + \psi\} \sin\{n(\omega/ \omega0)\pi\}\{\omega0/(\omega^2-\omega0^2)\}$$

If $\omega=\omega0$, the sum $H(\omega)^2$ of the squares is given as

$$H(\omega)^2 = (n^2\pi^2Ai^2) /\omega0^2 \qquad \text{equation 1}$$

On the other hand, if $\omega \neq \omega0$, the sum $H(\omega)^2$ of the squares is given as

$$H(\omega)^2 = 4 Ai^2\sin^2\{ n(\omega/ \omega0) \pi\}[\{\omega0^2/(\omega^2-\omega0^2)^2\}\cos^2\{n(\omega/ \omega0) \pi$$

$$+ \psi\}+ \{\omega^2/(\omega^2-\omega0^2)^2\}\sin^2\{n(\omega/ \omega0) \pi + \psi\}]$$

$$= 4 Ai^2 \sin^2\{ n(\omega/ \omega0) \pi\}[\{\omega0^2/(\omega^2-\omega0^2)^2\} + \{1/ (\omega^2-\omega0^2)\}$$

$$\sin^2\{n(\omega/\omega0) \pi + \psi\}] \qquad \text{equation 2}$$

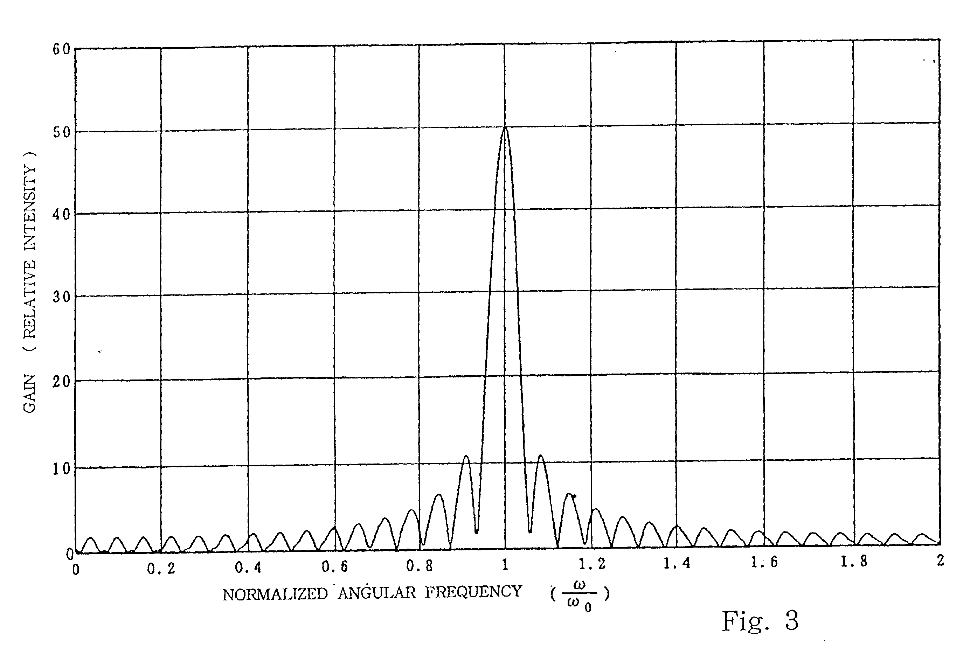

The present inventor plotted the sum $H(\omega)^2$ in figure 3 on the assumption that n is 32. When the angular frequency $\omega$ is spaced from the angular frequency $\omega0$, the gain is decreased.

In the first embodiment, the read only memory 1, the controller 10, the digital-to-analog converter 2 and the voltage-to-current converter 3 as a whole constitute a periodic signal generator, and the analog-to-digital converter 4 serves as a digital signal generator. The multiplier 5, the controller 10, the accumulator 6, the registers 7 and 8 and the microcomputer 9 as a whole constitute a data processor.

As will be understood from the foregoing description, the measuring apparatus according to the present invention stores the pieces of data information representative of the sine wave in the form of digital codes, and converts the ac voltage to the digital signal. This means that the impedance is determined through the digital signal processing. Only the quantizing noise is introduced into the digital signal supplied from the analog-to-digital converter 4 to the multiplier 5. The discrete values are stored in the form of digital code, and are directly supplied to the multiplier 5. This means that the digital signal is free from a noise component due to the dc offset voltage. When the accumulator 5 accumulates the products for N periods of the sine wave, the improvement of resolution is given as $1/2\log_2 N$. If N is 256, the resolution is improved by 4 bits. Thus, the digital signal processing is more accurate rather than the analog signal processing, and the measuring apparatus achieves a resolution higher than the prior art.

Moreover, the accumulator 6 extracts the dc components like a digital filter after the multiplication. This means that any low-pass filter is required for the elimination of the alternating current components. A condenser is incorporated in the low-pass filter, and the low-pass filter is undesirable for an integrated circuit. Any condenser is not incorporated in the accumulator 6, and the manufacturer easily integrates the components 1 to 10 on a semiconductor chip.

Second Embodiment

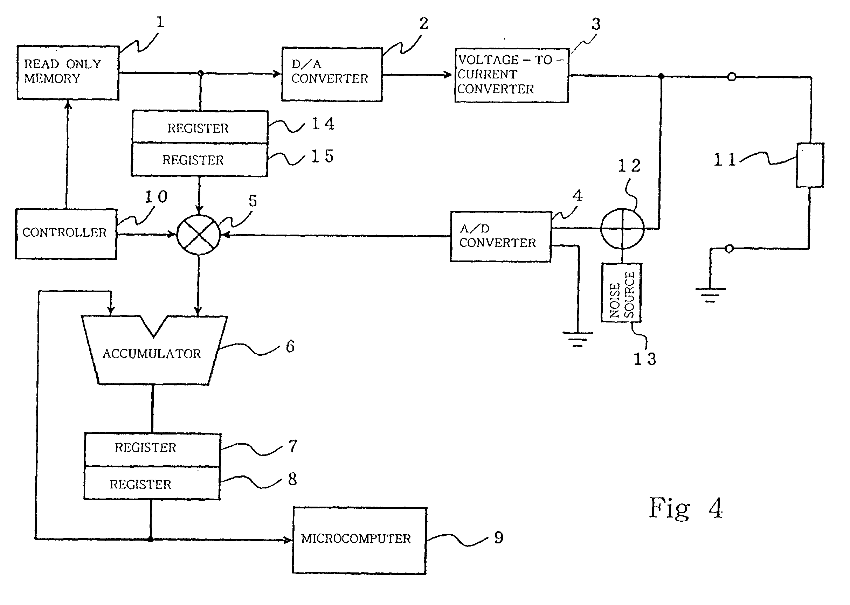

Figure 4 illustrates another apparatus embodying the present invention. A mixer 12, a noise source 13 and registers 14 and 15 are added to the measuring apparatus implementing the first embodiment, and the other components are corresponding to the components of the first embodiment. For this reason, the other components are labeled with references designating the corresponding components without detailed description. The register 14 is assigned to the discrete values representative of the sine wave, and the other register 15 is assigned to the discrete values representative of the cosine wave.

As described hereinbefore, the noise components introduced between the digital-to-analog conversion to the analog-to-digital conversion are eliminated from the sine term Hs($\omega$) and the cosine term H($\omega$) through the accumulation of the products. However, while the controller 10 is regularly reading out the discrete values from the read only memory 1, the quantizing noise is also regularly mixed into the digital signal supplied to the multiplier 5, and is hardly eliminated from the sine term Hs($\omega$) and the cosine term H($\omega$) through the accumulation of the products. The noise source 13 irregularly generates noise components, and the mixer 12 introduces the irregular noise component into the digital signal. The irregular noise component breaks the regularity of the quantizing noise component, and permits the accumulator 6 to eliminate the noise components from the sine term Hs($\omega$) and the cosine term H($\omega$).

The registers 14 and 15 temporarily store the discrete value representative of a part of the sine wave and the discrete value representative of a part of the cosine wave, and supplies them to the multiplier 5. The registers 14 and 15 make the control for the multiplication simple. Of course, the measuring apparatus implementing the second embodiment also achieves the advantages described in connection with the first embodiment.

In the second embodiment, the read only memory 1, the controller 10, the digital-to-analog converter 2 and the voltage-to-current converter 3 as a whole constitute a periodic signal generator, and the analog-to-digital converter 4, the noise source 13 and the mixer 12 form in combination a digital signal generator. The multiplier 5, the controller 10, the accumulator 6, the registers 7, 8, 14 and 15 and the microcomputer 9 as a whole constitute a data processor.

Third Embodiment

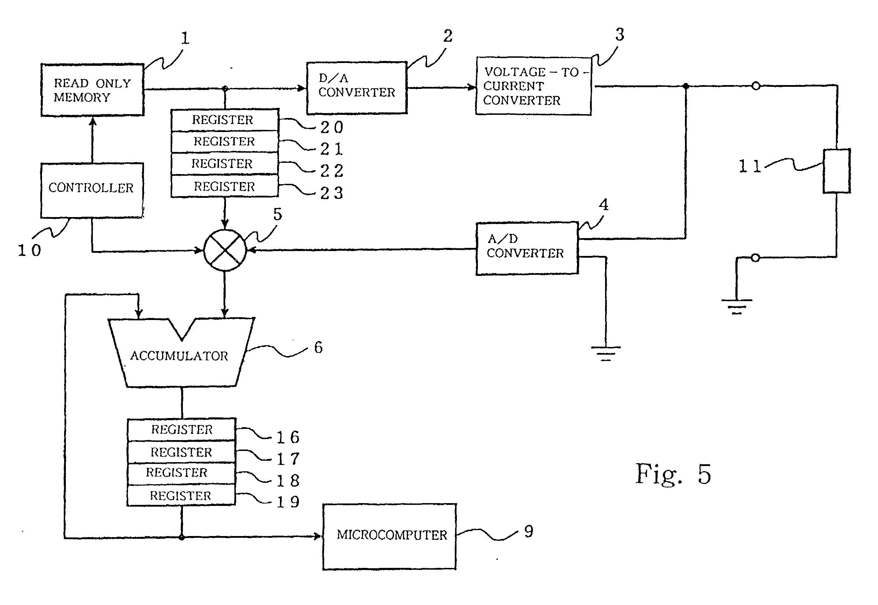

Figure 5 illustrates yet another measuring apparatus embodying the present invention. The registers 7, 8, 14 and 15 are replaced with plural registers 16/18, plural registers 17/19, plural registers 20/ 22 and plural registers 21/23, respectively. The other components are corresponding to the other components of the second embodiment, and are labeled with the same references without detailed description.

The read only memory 1 stores plural sets of discrete values representative of different sine waves. The plural registers 20 and 22 store discrete values representative of a sine wave at angular frequency f1 and discrete values representative of another sine wave at angular frequency f2. Similarly, the plural registers 21 and 23 store discrete values representative of a cosine wave at angular frequency f1 and discrete values representative of another cosine wave at angular frequency f2. On the other hand, the plural registers 16 and 18 store the sine term Hs($\omega$) at the angular frequency f1 and the sine term Hs($\omega$) at the angular frequency f2, and the plural registers 17 and 19 store the cosine term Hc($\omega$) at the angular frequency f1 and the cosine term Hc($\omega$) at the angular frequency f2. Thus, the apparatus implementing the third embodiment measures the impedance at different frequencies f1 and f2. This feature is desirable, because the impedance takes different values depending upon the angular frequency. Using the measuring apparatus implementing the third embodiment, user measures the impedance at different angular frequencies f1 and f2. The measuring apparatus implementing the third embodiment achieves all the advantages described in connection with the first embodiment.

Fourth Embodiment

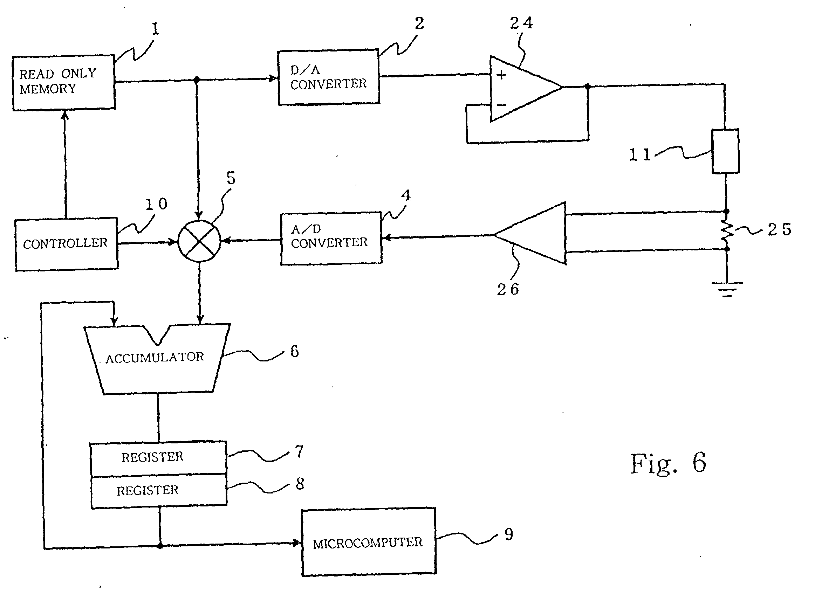

Figure 6 illustrates still another measuring apparatus embodying the present invention. The voltage-to-current converter 3 is replaced with a voltage follower 24. A resistor 25 and an ac amplifier 26 are added to the circuit configuration. The resistor 25 has resistance much smaller than the absolute value of the impedance of the object 11. The resistor 25 is connected between the object 11 and the ground, and the two input nodes of the ac amplifier 26 are connected to both ends of the resistor 25, respectively. In the first, second and third embodiments, the alternating current is supplied from the voltage-to-current converter 3 to the object 11, and is converted to the ac voltage. However, the present invention is never limited to the ac current. In the fourth embodiment, the voltage follower 24 applies an ac voltage to the object 11. The resistor 25 generates an extremely small voltage drop, and the extremely small voltage drop is amplified by the ac amplifier 26. The other features are similar to the first embodiment, and no further description is incorporated hereinbelow. The measuring apparatus implementing the fourth embodiment achieves all the advantages described in connection with the first embodiment.

In the fourth embodiment, the read only memory 1, the controller 10, the digital-to-analog converter 2 and the voltage follower 24 as a whole constitute a periodic signal generator. The resistor 25, the ac amplifier 26 and the analog-to-digital converter 4 form in combination a digital signal generator. The multiplier 5, the controller 10, the accumulator 6, the registers 7 and 8 and the microcomputer 9 as a whole constitute a data processor.

Method

The measuring apparatus measures the impedance through the following method. The method is described with reference to figure 2. The read only memory 1 stores the discrete values representative of a quarter of the sine wave. The discrete values are stored in the form of digital code, and are plotted on the quarter of the sine wave at predetermined time intervals. The controller 10 stores a pieces of control data representative of the predetermined time intervals and another piece of control data representative of predetermined periods for the accumulation.

The object 11 is connected between terminals T1 and T2 of the measuring apparatus. The measuring apparatus is energized. Then, the controller 10 reads out the discrete values at the predetermined time intervals, and the discrete values are supplied from the read only memory 1 to the digital-to-analog converter 2. The digital-to-analog converter 2 supplies the analog signal to the voltage-to-current converter 3, and the voltage-to-current converter 3 flows the alternating current into the object 11. As a result, the ac voltage takes place at the terminal T1, and is supplied to the analog-to-digital converter 4. The analog-to-digital converter 4 supplies the digital signal to the multiplier 5. The digital signals are multiplied by the discrete values representative of parts of the sine wave, and are successively added by the accumulator 6 over the predetermined periods. The sum is representative of the sine term Hs($\omega$), and is stored in the register 7. Moreover, the digital signals are multiplied by the discrete values representative of parts of the cosine wave, and are successively added by the accumulator 6 over the predetermined periods. The sum is representative of the cosine term Hc($\omega$), and is stored in the register 8.

Finally, the microcomputer 9 carries out the calculations on the sine term Hs($\omega$) and the cosine term Hc($\omega$), and determines the absolute value of the impedance, the value of the real part, the value of the imaginary part and the ratio between the real part and the imaginary part.

As will be appreciated from the foregoing description, the measuring apparatus carries out the digital data processing for determining the values of the impedance, and improves the resolution of the measurement and the accuracy of the values.

Although particular embodiments of the present invention have been shown and described, it will be apparent to those skilled in the art that various changes and modifications may be made without departing from the spirit and scope of the present invention.

For example, the read only memory may store discrete values representative of a part of cosine wave. In this instance, the controller 10 generates a sine wave together with the cosine wave.

A display or an indicator may be connected to the microcomputer 9 so as to show the impedance.

**Claims**

1. An apparatus for measuring an impedance of an object (11), comprising

   a port connected to said object (11),
   a periodic signal generator (1/2/3/10; 1/2/3/10); 1/2/10/24) connected to said port and supplying a first analog signal periodically varied and produced from a first digital signal through said port to said object (11) for generating a second analog signal varied due to said impedance,
   a digital signal generator (4; 4/12/13; 4/25/26) producing a second digital signal from said second analog signal, and
   a data processor (5/6/7/8/9; 6/7/8/9/14/15; 5/6/9/16/17/18/19/20/21/22/23) connected to said periodic signal generator and said digital signal generator and supplied with said first digital signal and said second digital signal for determining said impedance,

**characterized in that**

said first digital signal represents a series of discrete values on a sine wave and another series of discrete values on a cosine wave different in phase by 90 degree,

and **in that**

said second digital signal represents a first series of binary values related to a real part of said impedance and a second series of binary values related to an imaginary part of said impedance.

2. The apparatus as set forth in claim 1, in which said periodic signal generator includes

a memory (1) for storing digital codes representative of a part of said series of discrete values,

a controller (10) connected to said memory and repeatedly reading out said part of said series of discrete values in different orders in a time sharing fashion for producing said first digital signal, and

a digital-to-analog converter (2) connected between said memory and said port for producing an alternating current serving as said first analog signal.

3. The apparatus as set forth in claim 2, in which said part of said series of discrete value is on a quarter of said first periodic wave, and said controller (10) reads out said part of said series of discrete value from one end toward the other end, from said other end of said one end, from said one end toward said other end after an inversion of a polarity of said discrete values and from said other end to said one end under said inversion of said polarity.

4. The apparatus as set forth in claim 1, in which said periodic signal generator includes

a memory (1) for storing digital codes representative of a part of said series of discrete values,

a controller (10) connected to said memory and repeatedly reading out said part of said series of discrete values in different orders in a time sharing fashion for producing said first digital signal,

a digital-to-analog converter (2) connected between said memory for converting said first digital signal to an analog signal, and

a voltage follower (24) connected between said digital-to-analog converter and said port for producing an alternating current voltage serving as said first analog signal from said analog signal.

5. The apparatus as set forth in claim 4, in which said part of said series of discrete value is on a quarter of said first periodic wave, and said controller (10) reads out said part of said series of discrete value from one end toward the other end, from said other end of said one end, from said one end toward said other end after an inversion of a polarity of said discrete values and from said other end to said one end under said inversion of said polarity.

6. The apparatus as set forth in claim 1, in which said digital signal generator includes an analog-to-digital converter (4) connected between said port and said data processor.

7. The apparatus as set forth in claim 6, in which said digital signal generator further includes

a noise source (13) for generating a noise signal representative of an irregular noise, and

a mixer (12) having a first input node connected to said port, a second input node connected to said noise source and an output node connected to said analog-to-digital converter for mixing said second analog signal with said noise signal.

8. The apparatus as set forth in claim 6, in which said port has an output node connected to said object and an input node connected to said periodic signal generator for supplying an alternating current voltage serving as said first analog signal to said object, and said digital signal generator further includes a resistive element (25) connected between said output node of said port and a constant voltage source for generating a voltage signal varied between both ends thereof, an amplifier (26) having input nodes connected to said both ends, respectively for increasing the magnitude of said voltage signal and an output node connected to said analog-to-digital converter (4).

9. The apparatus as set forth in claim 1, in which said data processor includes

a multiplier (5) connected to said periodic signal generator and said digital signal generator for multiplying the first series of binary values and said second series of binary values by said series of discrete values and said another series of discrete values for producing first products and second products,

an accumulator (6) connected to said multiplier and accumulating said first products and said second products for producing a first sum of products and a second sum of products,

a first data storage (7/8; 16/17/18/19) for storing said first sum of products and said second sum of products, and

a computer (9) connected to said first data storage for determining said impedance on the basis of said first sum of products and said second sum of products.

10. The apparatus as set forth in claim 9, in which said computer (9) brings said first sum of products and said second sum of products to a first square and a second square, respectively, calculates the sum of said first square and said second square, and finds a square root of said sum for determining said impedance.

11. The apparatus as set forth in claim 9, in which said data processor further includes a second data storage (14/15) for separately storing said series of discrete values and said another series of discrete values.

12. The apparatus as set forth in claim 9, in which said accumulator (6) repeats the accumulation over predetermined periods for eliminating noise components from said first sum of products and said second sum of products.

13. The apparatus as set forth in claim 9, in which said series of discrete values has plural sub-series of discrete values on said first periodic wave at different frequencies, respectively, and said another series of discrete values has plural sub-series of discrete values on said second periodic wave at different frequencies.

14. The apparatus as set forth in claim 13, in which said computer determines plural values of said impedance at said different frequencies.

15. A method for measuring an impedance of an object, comprising the steps of:

    a) generating a first analog signal from a first digital signal;
    b) supplying said first analog signal to said object (11) for producing a second analog signal varied due to said impedance;
    c) converting said second analog signal to a second digital signal; and
    d) determining said impedance through a digital processing on said first digital signal and said second digital signal,

    **characterized in that**
    said first digital signal represents a series of discrete values on a sine wave and another series of discrete values on a cosine wave different in phase by 90 degree, and **in that**
    said second digital signal represents a first series of binary values related to a real part of said impedance and a second series of binary values related to an imaginary part of said impedance.

16. The method as set forth in claim 15, in which said step b) includes the sub-steps of

    b-1) supplying said first analog signal to said object (11) for producing a preliminary analog signal varied due to said impedance, and
    b-2) mixing a noise signal representative of an irregular noise with said preliminary analog signal for producing said second analog signal.

17. The method as set forth in claim 15, in which said first digital signal represents a series of discrete values on a first periodic wave and another series of discrete values on a second periodic wave, and said second digital signal represents a first series of binary values related to a real part of said impedance and a second series of binary values related to an imaginary part of said impedance, and
    said step d) includes the sub-steps of

    d-1) multiplying said first series of binary values and said second series of binary values by said series of discrete values and said another series of discrete values for producing first products and second products,
    d-2) accumulating said first products and said second products so as to obtain a first sum of products and a second sum of products,
    d-3) bringing said first sum of products and said second sum of products to a first square and a second square,
    d-4) calculating a sum of said first square and said second square, and
    d-5) finding a square root of said sum representative of an absolute value proportional to said impedance.

**Patentansprüche**

1.  Vorrichtung zum Messen der Impedanz eines Gegenstandes (11), mit:

    einem Port, der mit dem Gegenstand (11) verbunden ist;
    einem periodischen Signalgenerator (1/2/3/10; 1/2/3/10; 1/2/10/24), der mit dem Port verbunden ist, und der dem Gegenstand (11) durch den Port ein erstes Analogsignal, das periodisch variiert, zuführt, um ein zweites Analogsignal, welches infolge der Impedanz variiert, zu erzeugen,
    einem digitalen Signalgenerator (4; 4/12/13; 4/25/26), der aus dem zweiten Analogsignal ein zweites Digitalsignal erzeugt, und
    einem Datenprozessor (5/6/7/8/9; 6/7/8/9/14/15; 5/6/9/16/17/18/19/20/21/22/23), der mit dem periodischen Signalgenerator und dem Digitalsignalgenerator verbunden ist, und mit dem ersten Digitalsignal und dem zweiten Digitalsignal gespeist wird, um die Impedanz zu bestimmen,

    **dadurch gekennzeichnet, daß**
    das erste Digitalsignal eine Reihe von diskreten Werten einer Sinuswelle und eine weitere Reihe von diskreten Werten einer Cosinuswelle mit einem Phasenunterschied von 90°, repräsentiert, und daß
    das zweite Digitalsignal eine erste Reihe von binären Werten bezogen auf einen realen Teil der Impedanz und eine zweite Reihe von binären Werten bezogen auf einen imaginären Teil der Impedanz repräsentiert.

2.  Vorrichtung nach Anspruch 1,
    wobei der periodische Signalgenerator aufweist:

    einen Speicher (1) zum Speichern von Digitalcodes, die für einen Teil der Reihe von diskreten Werten repräsentativ sind,
    eine Steuerung (10), die mit dem Speicher verbunden ist und wiederholt den Teil der Reihe von diskreten Werten in unterschiedlichen Reihenfolgen nach Art eines Zeitmultiplex-Betriebes ausliest, um das erste Digitalsignal zu erzeugen, und
    einen Digital-/Analog-Wandler (2), der zwischen den Speicher und den Port geschaltet ist, um einen Wechselstrom zu erzeugen, der als das erste Analogsignal dient.

3.  Vorrichtung nach Anspruch 2,
    wobei der Teil der Reihe von diskreten Werten ein Viertel der ersten periodischen Welle ist, und die Steuerung (10) den Teil der Reihe der diskreten Werte von einem Ende zu dem anderen Ende von dem anderen Ende zu dem einen Ende, von dem einen Ende zu dem anderen Ende nach einer Inversion der Polarität der diskreten Werte und von dem anderen Ende zu dem einen Ende unter der Inversion der Polarität herausliest.

4.  Vorrichtung nach Anspruch 1,
    wobei der periodische Signalgenerator aufweist:

    einen Speicher (1) zum Speichern digitaler Codes, die für einen Teil der Reihe von diskreten Werten repräsentativ sind,
    eine Steuerung (10), die mit dem Speicher verbunden ist und wiederholt den Teil der Reihe diskreter Werte in unterschiedlicher Reihenfolge nach Art eines Zeitmultiplex-Betriebes herausliest, um das erste Digitalsignal zu erzeugen,
    einen Digital-/Analog-Wandler (2), der zwischen den Speicher zum Umwandeln des ersten digitalen Signals in ein Analogsignal geschaltet ist, und
    einen Spannungsfolger (24), der zwischen den Digital-/Analog-Wandler und den Port geschaltet ist, um aus dem Analogsignal eine Wechselspannung zu erzeugen, die als das erste Analogsignal dient.

5.  Vorrichtung nach Anspruch 4,
    wobei der Teil der Reihe von diskreten Werten ein Viertel der ersten periodischen Welle ist, und die Steuerung (10) den Teil der Reihe diskreter Werte von einem Ende zum anderen Ende, von dem anderen Ende zu dem einen Ende, von dem einen Ende zu dem anderen Ende nach einer Inversion der Polarität der diskreten Werte und von dem anderen Ende zu dem einen Ende unter der Inversion der Polarität liest.

6.  Vorrichtung nach Anspruch 1,
    wobei der Digitalsignalgenerator einen Analog-/Digital-Wandler (4) aufweist, der zwischen den Port und den Datenprozessor geschaltet ist.

**7.** Vorrichtung nach Anspruch 6,
wobei der Digitalsignalgenerator weiterhin aufweist:

eine Rauschquelle (13) zum Erzeugen eines Rauschsignals, das für ein unregelmäßiges Rauschen repräsentativ ist, und
eine Mischstufe (12) deren erster Eingangsknoten mit dem Port verbunden ist, deren zweiter Eingangsknoten mit der Rauschquelle verbunden ist, und deren Ausgangsknoten mit dem Analog-/Digital-Wandler verbunden ist, um das zweite Analogsignal mit dem Rauschsignal zu mischen.

**8.** Vorrichtung nach Anspruch 6,
wobei der Port einen Ausgangsknoten hat, der an den Gegenstand angeschlossen ist, und einen Eingangsknoten hat, der an den periodischen Signalgenerator angeschlossen ist, um eine Wechselspannung, die als das erste Analogsignal dient, dem Gegenstand zuzuführen, und der Digitalsignalgenerator ferner aufweist ein Widerstandselement (25), das zwischen den Ausgangsknoten des Ports und eine Konstantspannungsquelle geschaltet ist, um ein Spannungssignal zu erzeugen, das zwischen beiden Enden derselben variiert, einen Verstärker (26) mit Eingangsknoten, die an die jeweils beiden Enden angeschlossen sind, um die Größe des Spannungssignals zu erhöhen, und einem Ausgangsknoten, der mit dem Analog-/Digital-Wandler (4) verbunden ist.

**9.** Vorrichtung nach Anspruch 1,
wobei der Datenprozessor aufweist:

einen Multiplizierer (5), der mit dem periodischen Signalgenerator und dem Digitalsignalgenerator verbunden ist, um die erste Reihe von Binärwerten und die zweite Reihe von Binärwerten mit der Reihe von diskreten Werten und den anderen Reihen von diskreten Werten zu multiplizieren, um erste Produkte und zweite Produkte zu erzeugen,
einen Akkumulator (6), der mit dem Multiplizierer verbunden ist, und die ersten Produkte und die zweiten Produkte akkumuliert, um eine erste Produktsumme und eine zweite Produktsumme zu erzeugen,
einen ersten Datenspeicher (7/8; 16/17/18/19) zum Speichern der ersten Produktsumme und der zweiten Produktsumme, und
einen Computer (9), der mit dem ersten Datenspeicher verbunden ist, um die Impedanz auf der Basis der ersten Produktsumme und der zweiten Produktsumme zu bestimmen.

**10.** Vorrichtung nach Anspruch 9,
wobei der Computer (9) die erste Produktsumme und die zweite Produktsumme zu einem ersten Quadrat bzw. einem zweiten Quadrat erhebt, die Summe des ersten Quadrates und des zweiten Quadrates berechnet und eine Quadratwurzel aus der Summe zieht, um die Impedanz zu bestimmen.

**11.** Vorrichtung nach Anspruch 9,
wobei der Datenprozessor weiterhin einen zweiten Datenspeicher (14/15) zum Speichern der Reihe von diskreten Werten und der anderen Reihe von diskreten Werten aufweist.

**12.** Vorrichtung nach Anspruch 9,
wobei der Akkumulator (6) die Akkumulation über vorbestimmte Perioden wiederholt, um Rauschkomponenten aus der ersten Produktsumme und der zweiten Produktsumme zu eliminieren.

**13.** Vorrichtung nach Anspruch 9,
wobei die Reihe diskreter Werte jeweils mehrere Unterreihen diskreter Werte an der ersten periodischen Welle mit unterschiedlichen Frequenzen hat, und die andere Reihe diskreter Werte mehrere Unterreihen diskreter Werte an der zweiten periodischen Welle bei unterschiedlichen Frequenzen hat.

**14.** Vorrichtung nach Anspruch 13,
wobei der Computer mehrere Werte der Impedanz bei den unterschiedlichen Frequenzen bestimmt.

**15.** Verfahren zum Messen einer Impedanz eines Gegenstandes mit den Schritten:

a) Erzeugen eines ersten Analogsignals aus einem ersten Digitalsignal;

b) Zuführen des ersten Analogsignals zu dem Gegenstand (11) zum Erzeugen eines zweiten Analogsignals, welches infolge der Impedanz variiert;

c) Umwandeln des zweiten Analogsignals in ein zweites Digitalsignal; und

d) Bestimmen der Impedanz durch eine Digitalverarbeitung an dem ersten Digitalsignal und dem zweiten Digitalsignal,

**dadurch gekennzeichnet,daß**

das erste Digitalsignal eine Reihe von diskreten Werten einer Sinuswelle und eine weitere Reihe von diskreten Werten an einer Cosinuswelle mit einem Phasenunterschied von 90°, repräsentiert, und daß

das zweite Digitalsignal eine erste Reihe von Binärwerten bezogen auf einen realen Teil der Impedanz und eine zweite Reihe von Binärwerten bezogen auf einen imaginären Teil der Impedanz, repräsentiert.

**16.** Verfahren nach Anspruch 15,
wobei der Schritt

b) die Unterschritte aufweist:

b-1) Zuführen des ersten Analogsignals zu dem Gegenstand (11) zum Erzeugen eines vorläufigen Analogsignals, das infolge der Impedanz variiert, und

b-2) Mischen eines Rauschsignals, das für ein unregelmäßiges Rauschen repräsentativ ist, mit dem vorläufigen Analogsignal zum Erzeugen des zweiten Analogsignals.

**17.** Verfahren nach Anspruch 15,
wobei das erste Digitalsignal eine Reihe von diskreten Werten an einer ersten periodischen Welle und eine weitere Reihe von diskreten Werten an einer zweiten periodischen Welle repräsentiert, und das zweite Digitalsignal eine erste Reihe von Binärwerten bezogen auf einen realen Teil der Impedanz und eine zweite Reihe von Binärwerten bezogen auf einen imaginären Teil der Impedanz repräsentiert, und
der Schritt d) die Unterschritte aufweist:

d-1) Multiplizieren der ersten Reihe von Binärwerten und der zweiten Reihe von Binärwerten mit der Reihe diskreter Werte und der weiteren Reihe von diskreten Werten zum Erzeugen erster Produkte und zweiter Produkte;

d-2) Akkumulieren der ersten Produkte und der zweiten Produkte, um eine erste Produktsumme und eine zweite Produktsumme zu erhalten,

d-3) Erheben der ersten Produktsumme und der zweiten Produktsumme zu einem ersten Quadrat und einem zweiten Quadrat,

d-4) Berechnen der Summe aus dem ersten Quadrat und dem zweiten Quadrat, und

d-5) Bilden der Quadratwurzel aus dieser Summe als Repräsentation eines absoluten Wertes proportional zu der Impedanz.

**Revendications**

**1.** Appareil pour mesurer une impédance d'un objet (11), comprenant :

un port connecté audit objet (11),

un générateur de signal périodique (1/2/3/10 ; 1/2/3/10 ; 1/2/10/24) connecté audit port et appliquant un premier signal analogique périodiquement modifié et produit à partir d'un premier signal numérique, par l'intermédiaire dudit port, audit objet (11) pour générer un deuxième signal analogique modifié du fait de ladite impédance,

un générateur de signal numérique (4 ; 4/12/13 ; 14/25/26) produisant un deuxième signal numérique à partir dudit deuxième signal analogique, et

un processeur de données (5/6/7/8/9 ; 6/7/8/9/14/15 ; 5/6/9/16/17/18/19/20/21/22/23) connecté audit générateur de signal périodique et audit générateur de signal numérique et recevant ledit premier signal numérique et ledit deuxième signal numérique pour déterminer ladite impédance,

**caractérisé en ce que**

ledit premier signal numérique représente une série de valeurs discrètes sur une onde sinusoïdale et une autre série de valeurs discrètes sur une onde cosinusoïdale déphasées de 90°,

et **en ce que**

ledit deuxième signal numérique représente une première série de valeurs binaires concernant une partie réelle de ladite impédance et une deuxième série de valeurs binaires concernant une partie imaginaire de ladite impédance.

2. Appareil selon la revendication 1, dans lequel ledit générateur de signal périodique comprend :

une mémoire (1) pour mémoriser des codes numériques représentatifs d'une partie de ladite série de valeurs discrètes,
un contrôleur (10) connecté à ladite mémoire et extrayant de manière répétée ladite partie de ladite série de valeurs discrètes dans différents ordres en temps partagé pour produire ledit premier signal numérique, et
un convertisseur numérique-analogique (2) connecté entre ladite mémoire et ledit port pour produire un courant alternatif servant en tant que dit premier signal analogique.

3. Appareil selon la revendication 2, dans lequel ladite partie de ladite série de valeurs discrètes se trouve sur un quart de ladite première onde périodique, et ledit contrôleur (10) extrait ladite partie de ladite série de valeurs discrètes d'une première extrémité vers l'autre extrémité, de ladite autre extrémité vers ladite première extrémité, de ladite première extrémité vers ladite autre extrémité après une inversion d'une polarité desdites valeurs discrètes et de ladite autre extrémité vers ladite première extrémité sous ladite inversion de ladite polarité.

4. Appareil selon la revendication 1, dans lequel ledit générateur de signal périodique comprend :

une mémoire (1) pour mémoriser des codes numériques représentatifs d'une partie de ladite série de valeurs discrètes,
un contrôleur (10) connecté à ladite mémoire et extrayant de manière répétée ladite partie de ladite série de valeurs discrètes dans différents ordres en temps partagé pour produire ledit premier signal numérique,
un convertisseur numérique-analogique (2) connecté à ladite mémoire pour convertir ledit premier signal numérique en un signal analogique, et
un suiveur de tension (24) connecté entre ledit convertisseur numérique-analogique et ledit port pour produire une tension alternative servant en tant que dit premier signal analogique à partir dudit signal analogique.

5. Appareil selon la revendication 4, dans lequel ladite partie de ladite série de valeurs discrètes se trouve sur un quart de ladite première onde périodique, et ledit contrôleur (10) extrait ladite partie de ladite série de valeurs discrètes d'une première extrémité vers l'autre extrémité, de ladite autre extrémité vers ladite première extrémité, de ladite première extrémité vers ladite autre extrémité après une inversion d'une polarité desdites valeurs discrètes et de ladite autre extrémité vers ladite première extrémité sous ladite inversion de ladite polarité.

6. Appareil selon la revendication 1, dans lequel ledit générateur de signal numérique comprend un convertisseur analogique-numérique (4) connecté entre ledit port et ledit processeur de données.

7. Appareil selon la revendication 6, dans lequel ledit générateur de signal numérique comprend en outre :

une source de bruit (13) pour générer un signal de bruit représentatif d'un bruit irrégulier, et
un mélangeur (12) ayant un premier noeud d'entrée connecté audit port, un deuxième noeud d'entrée connecté à ladite source de bruit et un noeud de sortie connecté audit convertisseur analogique-numérique pour mélanger ledit deuxième signal analogique avec ledit signal de bruit.

8. Appareil selon la revendication 6, dans lequel ledit port a un noeud de sortie connecté audit objet et un noeud d'entrée connecté audit générateur de signal périodique pour fournir une tension alternative servant en tant que dit premier signal analogique audit objet, et ledit générateur de signal numérique comprend en outre un élément résistif (25) connecté entre ledit noeud de sortie dudit port et une source de tension constante pour générer un signal de tension modifié entre ses deux extrémités, un amplificateur (26) ayant des noeuds d'entrée respectivement connectés auxdites deux extrémités, pour augmenter l'amplitude dudit signal de tension et un noeud de sortie connecté audit convertisseur analogique-numérique (4).

9. Appareil selon la revendication 1, dans lequel ledit processeur de données comprend :

un multiplicateur (5) connecté audit générateur de signal périodique et audit générateur de signal numérique pour multiplier la première série de valeurs binaires et ladite deuxième série de valeurs binaires par ladite série de valeurs discrètes et ladite autre série de valeurs discrètes pour produire des premiers produits et des deuxièmes produits,

un accumulateur (6) connecté audit multiplicateur et cumulant lesdits premiers produits et lesdits deuxièmes produits pour produire une première somme de produits et une deuxième somme de produits,

une première mémoire de données (7/8 ; 16/17/18/19) pour mémoriser ladite première somme de produits et ladite deuxième somme de produits, et

un ordinateur (9) connecté à ladite première mémoire de données pour déterminer ladite impédance sur la base de ladite première somme de produits et de ladite deuxième somme de produits.

10. Appareil selon la revendication 9, dans lequel ledit ordinateur (9) élève ladite première somme de produits et ladite deuxième somme de produits, respectivement, à un premier carré et à un deuxième carré, calcule la somme dudit premier carré et dudit deuxième carré, et obtient une racine carrée de ladite somme pour déterminer ladite impédance.

11. Appareil selon la revendication 9, dans lequel ledit processeur de données comprend en outre une deuxième mémoire de données (14/15) pour mémoriser séparément ladite série de valeurs discrètes et ladite autre série de valeurs discrètes.

12. Appareil selon la revendication 9, dans lequel ledit accumulateur (6) répète le cumul sur des périodes prédéterminées pour éliminer les composantes de bruit de ladite première somme de produits et de ladite deuxième somme de produits.

13. Appareil selon la revendication 9, dans lequel ladite série de valeurs discrètes comporte plusieurs sous-séries de valeurs discrètes sur ladite première onde périodique à différentes fréquences, respectivement, et ladite autre série de valeurs discrètes comporte plusieurs sous-séries de valeurs discrètes sur ladite deuxième onde périodique à différentes fréquences.

14. Appareil selon la revendication 13, dans lequel ledit ordinateur détermine plusieurs valeurs de ladite impédance auxdites différentes fréquences.

15. Procédé pour mesurer une impédance d'un objet, comprenant les étapes consistant à :

a) générer un premier signal analogique à partir d'un premier signal numérique ;
b) appliquer ledit premier signal analogique audit objet (11) pour produire un deuxième signal analogique modifié du fait de ladite impédance ;
c) convertir ledit deuxième signal analogique en un deuxième signal numérique ; et
d) déterminer ladite impédance par un traitement numérique sur ledit premier signal numérique et sur ledit deuxième signal numérique,

**caractérisé en ce que**
ledit premier signal numérique représente une série de valeurs discrètes sur une onde sinusoïdale et une autre série de valeurs discrètes sur une onde cosinusoidale déphasées de 90°,
et **en ce que**
ledit deuxième signal numérique représente une première série de valeurs binaires concernant une partie réelle de ladite impédance et une deuxième série de valeurs binaires concernant une partie imaginaire de ladite impédance.

16. Procédé selon la revendication 15, dans lequel ladite étape b) comprend les sous-étapes consistant à :

b-1) appliquer ledit premier signal analogique audit objet (11) pour produire un signal analogique préliminaire modifié du fait de ladite impédance, et
b-2) mélanger un signal de bruit représentatif d'un bruit irrégulier avec ledit signal analogique préliminaire pour produire ledit deuxième signal analogique.

17. Procédé selon la revendication 15, dans lequel ledit premier signal numérique représente une série de valeurs discrètes sur une première onde périodique et une autre série de valeurs discrètes sur une deuxième onde périodique, et ledit deuxième signal numérique représente une première série de valeurs binaires concernant une partie réelle de ladite impédance et une deuxième série de valeurs binaires concernant une partie imaginaire de ladite impédance, et

ladite étape d) comprend les sous-étapes consistant à :

d-1) multiplier ladite première série de valeurs binaires et ladite deuxième série de valeurs binaires par ladite série de valeurs discrètes et ladite autre série de valeurs discrètes pour produire des premiers produits et des deuxièmes produits,

d-2) cumuler lesdits premiers produits et lesdits deuxièmes produits de manière à obtenir une première somme de produits et une deuxième somme de produits,

d-3) élever ladite première somme de produits et ladite deuxième somme de produits à un premier carré et à un deuxième carré,

d-4) calculer une somme dudit premier carré et dudit deuxième carré, et

d-5) obtenir une racine carrée de ladite somme représentative d'une valeur absolue proportionnelle à ladite impédance.

Fig. 1
PRIOR ART

Fig. 2

EP 1 115 002 B1

Fig. 3

EP 1 115 002 B1

Fig 4

EP 1 115 002 B1

READ ONLY MEMORY 1

CONTROLLER 10

REGISTER ~20
REGISTER ~21
REGISTER ~22
REGISTER ~23

D/A CONVERTER 2

VOLTAGE – TO – CURRENT CONVERTER 3

5

ACCUMULATOR 6

A/D CONVERTER 4

11

REGISTER ~16
REGISTER ~17
REGISTER ~18
REGISTER ~19

MICROCOMPUTER 9

Fig. 5

EP 1 115 002 B1

Fig. 6

EP 1 115 002 B1